# EUROPÄISCHE PATENTSCHRIFT

(11) **EP 0 766 073 B1**
(45) Veröffentlichungstag und Bekanntmachung des Hinweises auf die Patenterteilung: **02.01.2002**
(21) Anmeldenummer: 95115324.6
(22) Anmeldetag: 28.09.1995
(51) Int. Cl.: G01F 23/296, H05K 5/06

(54) **Elektronikgehäuse**
Electronic casing
Boîtier électronique

(43) Veröffentlichungstag der Anmeldung: 02.04.1997
(73) Patentinhaber: Endress + Hauser GmbH + Co., 79689 Maulburg (DE)
(72) Erfinder: Dreyer, Volker, D-79541 Lörrach (DE); Werner, Thomas, D-79689 Maulburg (DE)
(74) Vertreter: Schwepfinger, Karl-Heinz, Dipl.-Ing.

(56) Entgegenhaltungen:
- DE-A- 3 337 991
- DE-C- 4 233 185
- US-A- 3 838 316

## Beschreibung

Die Erfindung betrifft ein Elektronikgehäuse für eine zu einem elektrotechnischen Gerät gehörige Elektronik, das ein in einer Einfüllposition oben liegendes offenes Ende aufweist, durch das eine flüssige Vergußmasse eingefüllt wird und das nach dem Einfüllen der Vergußmasse durch einen Stopfen verschlossen wird.

Bei Elektronikgehäusen dieser Art wird zur Automatisierung der Fertigung eine stets gleich dosierte Menge der Vergußmasse abgemessen und eingefüllt. Dabei besteht das Problem, daß infolge von Fertigungstoleranzen und unterschiedlichen Größen der elektronischen Bauteile die auszufüllenden Hohlräume von Gerät zu Gerät verschieden sein können, so daß die gleiche Füllmenge zu unterschiedlichen Füllhöhen führen kann, was für die folgenden Fertigungsschritte unerwünscht ist. Wird die Füllmenge so bemessen, daß auch bei dem größtmöglichen Restvolumen die gewünschte Füllhöhe erreicht wird, kommt es bei kleinerem Restvolumen zu Überfüllungen. Wird dagegen die Füllmenge so bemessen, daß auch beim kleinstmöglichen Restvolumen keine Überfüllung stattfindet, dann wird bei größerem Restvolumen die gewünschte Füllhöhe nicht erreicht. Eine weitere Ursache für unterschiedliche Füllhöhen sind auch Ungenauigkeiten bei der Dosierung der Füllmenge.

Aufgabe der Erfindung ist die Schaffung eines Elektronikgehäuses der eingangs angegebenen Art, bei welchem unabhängig von Fertigungs- und Dosierungsschwankungen und unabhängig von unterschiedlichen Bauteilegrößen bei stets gleicher Füllmengendosierung die gewünschte Füllhöhe genau eingehalten wird.

Diese Aufgabe wird nach der Erfindung dadurch gelöst, daß in dem Elektronikgehäuse ein Überlaufrohr angeordnet ist, dessen oberes Ende in der Einfüllposition auf der Höhe des gewünschten Füllstands im Elektronikgehäuse liegt und dessen unteres Ende mit einem Auffangraum für die in das Überlaufrohr abfließende Überlaufmenge der Vergußmasse in Verbindung steht.

Beim Einfüllen der Vergußmasse in das Elektronikgehäuse nach der Erfindung wird die Einfüllmenge so bemessen, daß auch beim größten vorkommenden Restvolumen die gewünschte Füllhöhe erreicht wird. Bei kleinerem Restvolumen fließt die überschüssige Vergußmasse in das Überlaufrohr. Diese Überlaufmenge sammelt sich in dem Auffangraum an.

Wenn das Überlaufrohr einen ausreichend großen Querschnitt hat, kann es am unteren Ende verschlossen sein, so daß der untere Teil des Überlaufrohrs selbst den Auffangraum bildet.

Wenn das Elektronikgehäuse an seinem dem offenen Ende entgegengesetzten Ende mit dem elektrotechnischen Gerät verbunden ist, zu dem die Elektronik gehört, wird vorzugsweise im Bereich der Verbindung zwischen dem Elektronikgehäuse und dem elektrotechnischen Gerät eine Luftkammer gebildet, die von dem Raum getrennt ist, der mit Vergußmasse gefüllt wird. Das in der Luftkammer eingeschlossene Luftvolumen wirkt im Betrieb des Geräts als Temperaturbarriere zwischen dem elektrotechnischen Gerät und dem Elektronikgehäuse, wodurch der Wärmetransport zur Elektronik reduziert wird. Wenn eine solche Luftkammer vorhanden ist, kann das Überlaufrohr am unteren Ende mit der Luftkammer in Verbindung stehen, die dann den Auffangraum für die Überlaufmenge bildet.

In beiden Fällen ist das Gesamtvolumen des Überlaufrohres und des Auffangsraums wesentlich größer als die größte vorkommende Überlaufmenge der Vergußmasse. Somit verbleibt im Überlaufrohr und im Auffangraum ein Luftvolumen, das im Betrieb den Überdruck aufnimmt, der im Elektronikgehäuse entsteht, wenn sich die Vergußmasse bei Erwärmung ausdehnt.

Weitere Merkmale und Vorteile der Erfindung ergeben sich aus der folgenden Beschreibung von Ausführungsbeispielen, die in den Zeichnungen dargestellt sind. In den Zeichnungen zeigen:
- Fig. 1: eine teilweise geschnittene Ansicht eines elektromechanischen Füllstandssensors mit einer ersten Ausführungsform des Elektronikgehäuses nach der Erfindung vor dem Einsetzen des getrennt dargestellten Stopfens,
- Fig. 2: das Gerät von Fig. 1 nach dem Einsetzen des Stopfens und
- Fig. 3: eine teilweise geschnittene Ansicht des elektromechanischen Füllstandssensors mit einer zweiten Ausführungsform des Elektronikgehäuses nach der Erfindung im zusammengebauten Zustand.

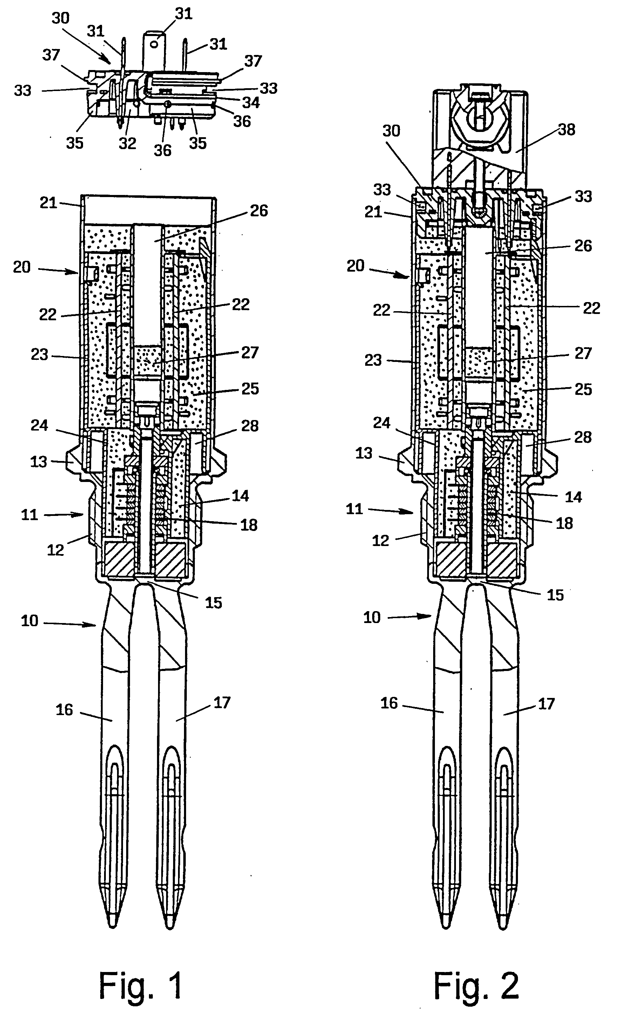

Die Figuren 1 und 2 der Zeichnung zeigen als Beispiel für ein elektrotechnisches Gerät, bei dem die Erfindung anwendbar ist, einen elektromechanischen Füllstandssensor 10 für die Überwachung eines vorbestimmten Füllstands in einem Behälter, wie er beispielsweise aus der deutschen Offenlegungsschrift DE 42 33 185 C1 bekannt ist. Der Füllstandssensor 10 hat ein Einschraubstück 11 mit einem Gewindeabschnitt 12 und einem Sechskantkopf 13. Der Innenraum 14 des Einschraubstücks 11 ist hohl und am unteren Ende durch eine Membran 15 verschlossen, an der die Enden von zwei Schwingstäben 16 und 17 befestigt sind. Mittels des Einschraubstücks 11 wird der Füllstandssensor 10 so in einer mit einem Innengewinde versehenen Öffnung der Behälterwand befestigt, daß die Schwingstäbe 16, 17 in das Innere des Behälters ragen und mit dem Füllgut in Berührung kommen, wenn dieses den zu überwachenden Füllstand erreicht.

In dem hohlen Innenraum 14 des Einschraubstücks 11 ist eine elektromechanische Wandleranordnung 18 angeordnet, die durch einen Stapel von piezoelektrischen Elementen gebildet ist. Die Wandleranordnung 18 enthält Erregungswandler und Empfangswandler. Wenn an die Erregungswandler eine elektrische Wechselspannung angelegt wird, versetzen sie die Membran 15 in Schwingungen, die auf die Schwingstäbe 16 und 17 übertragen werden, so daß diese entgegengesetzte Schwingungen quer zu ihrer Längsrichtung ausführen. Wenn auf die Empfangswandler mechanische Schwingungen einwirken, erzeugen sie eine elektrische Wechselspannung mit der Frequenz der mechanischen Schwingungen. Eine zugehörige Elektronik enthält einen Verstärker, der am Eingang die von den Empfangswandlern erzeugte Wechselspannung empfängt und am Ausgang die verstärkte Wechselspannung zu den Erregungswandlern überträgt. Somit liegt das von der Membran 15 und den Schwingstäben 16, 17 gebildete mechanische Schwingsystem über die Wandleranordnung 18 im Rückkopplungskreis des Verstärkers, so daß es sich zu Schwingungen mit einer Eigenresonanzfrequenz erregt.

Die Funktion des Füllstandssensors 10 beruht auf folgender Erscheinung: Wenn die Schwingstäbe 16, 17 nicht mit dem Füllgut in Berührung stehen, ist die Eigenresonanzfrequenz des mechanischen Schwingsystems höher als wenn die Schwingstäbe 16, 17 in das Füllgut eintauchen. Die zugehörige Elektronik enthält daher zusätzlich eine Auswerteschaltung, die feststellt, ob die Frequenz der vom Verstärker abgegebenen Wechselspannung, die mit der Frequenz der mechanischen Schwingung übereinstimmt, über oder unter einem vorgegebenen Schwellenwert liegt. Wenn diese Frequenz über dem Schwellenwert liegt, bedeutet dies, daß die Schwingstäbe 16, 17 in Luft schwingen, also das Füllgut den zu überwachenden Füllstand nicht erreicht hat. Wenn dagegen die Frequenz unter dem Schwellenwert liegt, bedeutet dies, daß das Füllgut im Behälter den zu überwachenden Füllstand erreicht oder überschritten hat.

Zur Unterbringung der Elektronik ist an der außerhalb des Behälters liegenden Stirnseite des Einschraubstücks 11 ein Elektronikgehäuse 20 angebracht. Die Wand des Elektronikgehäuses 20 ist durch ein Metallrohr 21 gebildet, das am einen Ende an dem Einschraubstück 11 dicht befestigt ist und dessen entgegengesetztes Ende offen ist. Die Elektronik ist in üblicher Weise durch elektronische Bauteile gebildet, die auf Leiterplatten 22 montiert sind. In das Innere des Elektronikgehäuses 20 ist eine durch ein Kunststofformteil gebildete Hülse 23 eingesetzt, die an der Innenfläche des Metallrohres 21 anliegt und die Elektronik im Inneren des Elektronikgehäuses 20 umgibt. Die Hülse 23 weist am unteren Ende eine Verlängerung 24 von kleinerem Durchmesser auf, die in den hohlen Innenraum 14 des Einschraubstücks 11 ragt und die Wandleranordnung 18 umgibt. Die Hülse 23 erleichtert das Anbringen der Elektronik im Elektronikgehäuse 20: die Elektronik kann außerhalb des Elektronikgehäuses 20 in der Hülse 23 angeordnet und dann zusammen mit der Hülse 23 in das Elektronikgehäuse 20 eingesetzt werden.

Nachdem die Hülse 23 mit der Elektronik in das Elektronikgehäuse 20 eingesetzt worden ist, werden die Hohlräume im Elektronikgehäuse 20 und im Einschraubstück 11 mit einer Vergußmasse 25 ausgefüllt, die durch das offene Ende des Elektronikgehäuses 20 in flüssigem Zustand eingefüllt wird und dann aushärtet. Die Vergußmasse ist beispielsweise ein weicher, gelartiger Zweikomponenten-Silikonkautschuk, der nach dem Mischen der beiden Komponenten flüssig ist und dann durch Additionsvernetzung vulkanisiert. Zum Einfüllen der Vergußmasse muß das Gerät in die in Fig. 1 dargestellte vertikale Position gebracht werden, in der das offene Ende des Elektronikgehäuses 20 oben liegt. Im Betrieb kann das Gerät dagegen in jeder beliebigen Lage montiert werden; gewöhnlich werden Füllstandssensoren der beschriebenen Art in der Seitenwand des Behälters auf der Höhe des zu überwachenden Füllstands horizontal angebracht. Die im folgenden verwendeten Begriffe "oben" und "unten" beziehen sich auf die in der Zeichnung dargestellte Einfüllposition.

Fig. 1 zeigt das Gerät nach dem Einfüllen der punktiert dargestellten Vergußmasse 25. Zur Automatisierung der Fertigung wird hierzu eine stets gleich dosierte Menge abgemessen und eingefüllt. Dabei besteht das Problem, daß infolge von Fertigungstoleranzen und unterschiedlichen Größen der elektronischen Bauteile die auszufüllenden Hohlräume von Gerät zu Gerät verschieden sein können, so daß die gleiche Füllmenge zu unterschiedlichen Füllhöhen führen kann, was für die folgenden Fertigungsschritte unerwünscht ist. Wird die Füllmenge so bemessen, daß auch bei dem größtmöglichen Restvolumen die gewünschte Füllhöhe erreicht wird, kommt es bei kleinerem Restvolumen zu Überfüllungen. Wird dagegen die Füllmenge so bemessen, daß auch beim kleinstmöglichen Restvolumen keine Überfüllung stattfindet, dann wird bei größerem Restvolumen die gewünschte Füllhöhe nicht erreicht. Eine weitere Ursache für unterschiedliche Füllhöhen sind auch Ungenauigkeiten bei der Dosierung der Füllmenge.

Das dargestellte Elektronikgehäuse 20 ist so ausgebildet, daß unabhängig von Fertigungs- und Dosierungsschwankungen und unabhängig von unterschiedlichen Bauteilegrößen bei stets gleicher Füllmengendosierung die gewünschte Füllhöhe genau eingehalten wird. Zu diesem Zweck ist in dem Elektronikgehäuse 20 ein Überlaufrohr 26 so angebracht, daß sein oberes Ende auf der gewünschten Füllhöhe unterhalb des oberen Randes des Elektronikgehäuses liegt. Bei dem in Fig. 1 und 2 dargestellten Ausführungsbeispiel ist das Überlaufrohr 26 koaxial zum Elektronikgehäuse 20 angeordnet. Es ist am unteren Ende verschlossen und hat einen verhältnismäßig großen Durchmesser, so daß sein Volumen wesentlich größer als die größte vorkommende Überlaufmenge der Vergußmasse 25 ist. Die Einfüllmenge der Vergußmasse 25 wird so bemessen, daß auch beim größten vorkommenden Restvolumen die gewünschte Füllhöhe erreicht wird. Bei kleinerem Restvolumen fließt die überschüssige Vergußmasse in das Überlaufrohr 26. Diese Überlaufmenge 27 sammelt sich im unteren Teil des Überlaufrohres 26 an, der als Auffangraum dient. Infolge des verhältnismäßig großen Volumens des Überlaufrohres bleibt aber auch bei der größten vorkommenden Überlaufmenge 27 ein beträchtliches Luftvolumen im Überlaufrohr 26 bestehen.

Somit wird die Füllhöhe der Vergußmasse 25 im Elektronikgehäuse 20 stets genau auf der Höhe des oberen Randes des Überlaufrohres 26 gehalten.

Im Übergangsbereich zwischen dem Elektronikgehäuse 20 und dem Einschraubstück 11 ist an die Hülse 23 eine ringförmige Luftkammer 28 angeformt, die in keiner Verbindung mit dem Volumen steht, das die Vergußmasse 25 aufnimmt, so daß die Luftkammer 28 auch nach dem Einfüllen der Vergußmasse 25 mit Luft gefüllt bleibt.

Sofort nach dem Einfüllen der Vergußmasse 25, während sich diese noch in flüssigem Zustand befindet, wird das offene Ende des Elektronikgehäuses 20 durch einen Stopfen 30 verschlossen, der in Fig. 1 oberhalb des noch offenen Elektronikgehäuses 20 dargestellt ist. Der Stopfen 30 ist ein beispielsweise durch Spritzguß hergestelltes Kunststoff-Formteil und dient außer zum Verschließen des Elektronikgehäuses 20 auch zur Verbindung der im Elektronikgehäuse 20 untergebrachten Elektronik mit äußeren Leitungen. Zu diesem Zweck sind in den Stopfen 30 metallische Kontaktteile 31 eingesetzt, die an der dem Innern des Elektronikgehäuses 20 zugewandten Unterseite des Stopfens 30 hervorstehende Kontaktspitzen aufweisen und an der außenliegenden Oberseite des Stopfens 30 flache Kontaktzungen bilden, auf die ein Steckverbindungsteil aufgesteckt werden kann. In die Unterseite des Stopfens 30 ist eine Ausnehmung 32 eingeformt, und rings um den Stopfen 30 verläuft eine Umfangsnut 33. Der unterhalb der Umfangsnut 33 liegende Randbereich 34 des Stopfens 30 geht in einen Umfangsrand 35 über, der die Ausnehmung 32 umgibt und einen etwas kleineren Außendurchmesser als der Randbereich 34 aufweist. Durch diesen Umfangsrand 35 verlaufen Entlüftungslöcher 36 von der Ausnehmung 32 zum Außenumfang. Ein oberhalb der Umfangsnut 33 gebildeter vorspringender Rand 37 begrenzt das Eindringen des Stopfens 30 in das Elektronikgehäuse 20. Wenn der Stopfen 30 vollständig eingeführt ist, liegt der Rand 37 auf dem oberen Rand des Elektronikgehäuses 20 auf (Fig. 2).

Beim Einsetzen des Stopfens 30 in das offene Ende des Elektronikgehäuses 20 kann Luft, die sich über der Oberfläche der Vergußmasse 25 befindet, durch die Entlüftungslöcher 36 nach außen entweichen. Beim weiteren Einführen des Stopfens 30 tauchen die Spitzen der Kontaktteile 31 und der Umfangsrand 35 in die Vergußmasse 25 ein, wodurch noch etwas Vergußmasse verdrängt wird, die in das Überlaufrohr 26 abfließt. Wenn schließlich der Stopfen 30 vollständig eingeführt ist (Fig. 2), ragt das Überlaufrohr 26 bis in die Ausnehmung 32, so daß auch ein Teil der Ausnehmung 32 mit Vergußmasse 25 gefüllt ist.

Zwischen dem Randbereich 34 des Stopfens 30 und der Innenfläche des Metallrohres 21 besteht ein Spalt, der so bemessen ist, daß Vergußmasse, die in den Zwischenraum zwischen dem Umfangsrand 35 und dem Metallrohr 21 eindringt, durch die Kapillarwirkung nach oben in die Umfangsnut 36 gezogen wird.Diese aufsteigende Vergußmasse sammelt sich in der Umfangsnut 33 an, wodurch zwei Wirkungen erzielt werden: einerseits wird verhindert, daß die aufsteigende Vergußmasse nach außen austritt, und andererseits ergibt die in der Umfangsnut 33 angesammelte Vergußmasse, wenn sie ausgehärtet ist, eine gute Abdichtung des Spaltes zwischen dem Stopfen 30 und der Wand des Elektronikgehäuses 20.

Fig. 2 zeigt das Gerät im vollständig zusammengebauten Zustand. Die von der Unterseite des Stopfens 30 nach unten ragenden Spitzen der Kontaktteile 31 stehen mit Gegenkontaktstücken der Elektronik in Eingriff. Auf die nach oben ragenden flachen Kontaktzungen der Kontaktteile 31 ist ein mit einem Kabel verbundenes Steckverbindungsteil 38 aufgesteckt. Dadurch ist die Verbindung von dem Kabel zu der Elektronik im Elektronikgehäuse 20 hergestellt.

Weiche Vergußmassen der hier verwendeten Art haben die Eigenschaft, daß sie die Wärme gut leiten und sich bei Erwärmung relativ stark ausdehnen. Das in der Luftkammer 28 eingeschlossene Luftvolumen wirkt im Betrieb des Geräts als Temperaturbarriere zwischen dem mit dem Behälter verbundenen Einschraubstück 11 und dem Elektronikgehäuse 20, wodurch der Wärmetransport vom Füllstandssensor zur Elektronik reduziert wird. Das im Überlaufrohr 26 vorhandene Luftvolumen nimmt den Überdruck auf, der im Elektronikgehäuse 20 entsteht, wenn sich die Vergußmasse bei Erwärmung ausdehnt.

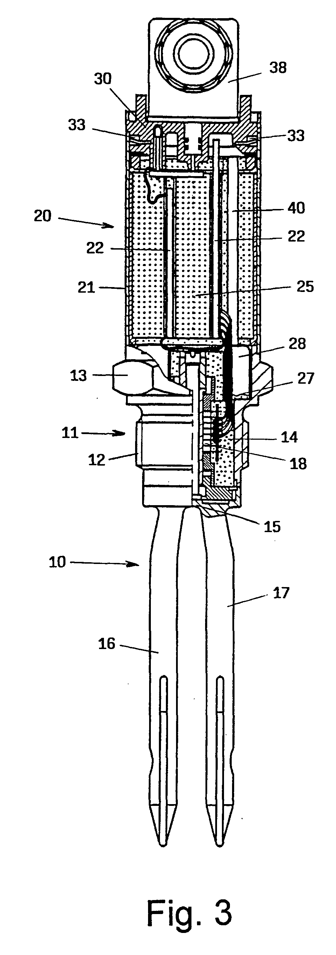

Fig. 3 zeigt eine abgeänderte Ausführungsform des Elektronikgehäuses 20, das an einen Füllstandssensor von gleicher Art wie in den Figuren 1 und 2 angebaut ist. Die Bestandteile des Füllstandssensors 10 und des Elektronikgehäuses 20 stimmen mit denjenigen der Ausführungsform von Fig. 1 und 2 weitgehend überein und sind daher mit den gleichen Bezugszeichen wie in den Figuren 1 und 2 bezeichnet. Der einzige wesentliche Unterschied zwischen der Ausführungsform von Fig. 3 und derjenigen von Fig. 1 und 2 besteht in dem Überlaufrohr, das in Fig. 3 mit 40 bezeichnet ist: Das Überlaufrohr 40 liegt nicht mehr koaxial zum Elektronikgehäuse 20, sondern an einer gegen die Achse versetzten Stelle, und es steht am unteren Ende mit der im Einschraubstück 11 gebildeten Luftkammer 28 in Verbindung. Daher dient in diesem Fall die Luftkammer 28 auch als Auffangraum für die Überlaufmenge 27 der Vergußmasse 25, die sich am Boden der Luftkammer 28 ansammelt. Ferner wird ein im Elektronikgehäuse 20 entstehender Überdruck von dem gesamten Luftvolumen in der Luftkammer 28 und im Überlaufrohr 40 aufgenommen. Aus beiden Gründen kann das Überlaufrohr mit wesentlich kleinerem Querschnitt als bei der Ausführungsform von Fig. 1 und 2 ausgebildet sein.

## Patentansprüche

1. Elektronikgehäuse für eine zu einem elektrotechnischen Gerät (10) gehörige Elektronik, das ein in einer Einfüllposition oben liegendes offenes Ende aufweist, durch das eine flüssige Vergußmasse (25) eingefüllt wird und das nach dem Einfüllen der Vergußmasse (25) durch einen Stopfen (30) verschlossen wird, **dadurch gekennzeichnet, daß** in dem Elektronikgehäuse (20) ein Überlaufrohr (26; 40) angeordnet ist, dessen oberes Ende in der Einfüllposition auf der Höhe des gewünschten Füllstands im Elektronikgehäuse (20) liegt und dessen unteres Ende mit einem Auffangraum für die in das Überlaufrohr (26; 40) abfließende Überlaufmenge (27) der Vergußmasse (25) in Verbindung steht.

2. Elektronikgehäuse nach Anspruch 1, **dadurch gekennzeichnet, daß** das Elektronikgehäuse (20) an seinem dem offenen Ende entgegengesetzten Ende mit dem elektrotechnischen Gerät (10) verbunden ist, zu dem die Elektronik gehört.

3. Elektronikgehäuse nach Anspruch 2, **dadurch gekennzeichnet, daß** im Bereich der Verbindung zwischen dem Elektronikgehäuse (20) und dem elektrotechnischen Gerät (10) eine Luftkammer (28) gebildet ist, die von dem Raum getrennt ist, der mit Vergußmasse (25) gefüllt wird.

4. Elektronikgehäuse nach Anspruch 3, **dadurch gekennzeichnet, daß** das Überlaufrohr (40) am unteren Ende mit der Luftkammer (28) in Verbindung steht, die den Auffangraum für die Überlaufmenge (27) bildet.

5. Elektronikgehäuse nach einem der Ansprüche 1 bis 3, **dadurch gekennzeichnet, daß** das untere Ende des Überlaufrohres (26) verschlossen ist und daß der untere Teil des Überlaufrohres (40) den Auffangraum für die Überlaufmenge (27) bildet.

6. Elektronikgehäuse nach einem der Ansprüche 1 bis 5, **dadurch gekennzeichnet, daß** der Stopfen (30) eine Umfangsnut (33) aufweist und daß zwischen dem Außenumfang des Stopfens (30) und der Wand des Elektronikgehäuses (20) ein Spalt besteht, der so bemessen ist, daß Vergußmasse (25) durch Kapillarwirkung in die Umfangsnut (33) gezogen wird.

## Claims

1. An electronics enclosure for an electronics assembly belonging to an electrotechnical apparatus (10), comprising an open end located at the top in a filling position, through which a fluid potting compound (25) is filled and which is closed off by a plug (30) after filling in of the potting compound (25), **characterized in that** in the electronics enclosure (20) a spill tube (26; 40) is disposed, the top end of which is located in the filling position at the same level with the desired filling height in the electronics enclosure (20) and the bottom end of which is in communication with a catchment space for the spill quantity (27) of the potting compound (25) flowing into the spill tube (26; 40).

2. The electronics enclosure as set forth in claim 1, **characterized in that** the electronics enclosure (20) is connected at its end opposite to the open end to the electrotechnical apparatus (10) to which the electronics assembly belongs.

3. The electronics enclosure as set forth in claim 2, **characterized in that** in the region of the connection between the electronics enclosure (20) and the electrotechnical apparatus (10) an air chamber (28) is formed which is separated from the space being filled with potting compound (25).

4. The electronics enclosure as set forth in claim 3, **characterized in that** the spill tube (40) is in communication at its bottom end with the air chamber (28) which forms the catchment space for the spill quantity (27).

5. The electronics enclosure as set forth in any of the claims 1 to 3, **characterized in that** the bottom end of the spill tube (26) is closed off and the lower part of the spill tube (40) forms the catchment space for the spill quantity (27).

6. The electronics enclosure as set forth in any of the claims 1 to 5, **characterized in that** the plug (30) comprises a peripheral groove (33) and that between the outer periphery of the plug (30) and the wall of the electronics enclosure (20) a gap exists which is dimensioned such that potting compound (25) is drawn into the peripheral groove (33) by the capillary effect.

## Revendications

1. Boîtier électronique pour un système électronique appartenant à un appareil électrotechnique (10), qui présente une extrémité ouverte située au sommet dans une position de remplissage, à travers laquelle est remplie une masse de scellement (25) liquide et qui est fermée par un bouchon (30) après avoir rempli la masse de scellement (25), **caractérisé en ce que** dans le boîtier électronique (20) est agencé un tube de trop-plein (26 ; 40) dont l'extrémité supérieure est située, dans la position de remplissage, à la hauteur du niveau de remplissage souhaité dans le boîtier électronique (20) et dont l'extrémité inférieure est en liaison avec un espace collecteur pour la quantité débordante (27) de la masse de scellement (25) qui s'écoule dans le tube de trop-plein.

2. Boîtier électronique selon la revendication 1, **caractérisé en ce qu'**à son extrémité opposée à l'extrémité ouverte, le boîtier électronique (20) est relié à l'appareil électrotechnique auquel appartient le système électronique.

3. Boîtier électronique selon la revendication 2, **caractérisé en ce que** dans la zone de liaison entre le boîtier électronique (20) et l'appareil électrotechnique (10) est formée une chambre d'air (28) qui est séparée de l'espace qui est rempli de masse de scellement (25).

4. Boîtier électronique selon la revendication 3, **caractérisé en ce qu'**à son extrémité inférieure, le tube de trop-plein (40) est en liaison avec la chambre d'air (48) qui forme l'espace collecteur pour la quantité débordante (27).

5. Boîtier électronique selon l'une quelconque des revendications 1 à 3, **caractérisé en ce que** l'extrémité inférieure du tube de trop-plein (26) est fermée et **en ce que** la partie inférieure du tube de trop-plein (40) forme l'espace collecteur pour la quantité débordante (27).

6. Boîtier électronique selon l'une quelconque des revendications 1 à 5, **caractérisé en ce que** le bouchon (30) présente une gorge périphérique (33) et **en ce qu'**il existe entre la périphérie extérieure du bouchon (30) et la paroi du boîtier électronique (20) une fente dont les dimensions sont telles que la masse de scellement (25) est tirée par effet de capillarité dans la gorge périphérique (33).
